# EUROPEAN PATENT SPECIFICATION

(11) **EP 2 823 697 B1**
(45) Date of publication and mention of the grant of the patent: **11.09.2019**
(21) Application number: 12780206.4
(22) Date of filing: 02.11.2012
(51) Int. Cl.: H05K 9/00

(54) **HALOGEN-FREE FLAME RETARDANT EMI SHIELDING GASKET FOR ELECTRONIC APPARATUS**
HALOGENFREIE FLAMMWIDRIGE EMV-ABSCHIRMDICHTUNG FÜR EINE ELEKTRONISCHE VORRICHTUNG
JOINT D'ÉTANCHÉITÉ DE PROTECTION CONTRE LES INTERFÉRENCES ÉLECTROMAGNÉTIQUES IGNIFUGE ET SANS HALOGÈNE DESTINÉ À UN APPAREIL ÉLECTRONIQUE

(30) Priority: 03.11.2011 US 201161555054 P
(43) Date of publication of application: 14.01.2015
(73) Proprietor: Lo, Chi-cheong, Shatin, N.T Hong-Kong (CN); Kwok, Ka, Ho, Shatin, N.T Hong-Kong (CN); Andy, Lo, Tsz Shing, Shatin, N.T Hong-Kong (CN); Brull, Christian, 4600 Vise (BE)
(72) Inventor: Lo, Chi-cheong, Shatin, N.T Hong-Kong (CN); Kwok, Ka, Ho, Shatin, N.T Hong-Kong (CN); Andy, Lo, Tsz Shing, Shatin, N.T Hong-Kong (CN); Brull, Christian, 4600 Vise (BE)
(74) Representative: Regimbeau
(86) International application number: PCT/EP2012/071771
(87) International publication number: WO 2013/064671

(56) References cited:
- WO-A1-94/14309
- WO-A2-2009/085660
- JP-A- 2003 258 480
- US-A1- 2001 031 589
- US-A1- 2002 010 223
- US-A1- 2006 103 081
- US-A1- 2010 258 344
- US-B1- 6 447 567

## Description

### BACKGROUND OF THE INVENTION

### (1) Field of the invention

The operation of electronic devices generates electromagnetic radiation from within the electronic circuitry of the equipment, which may interfere with other electronic equipment. Conductive shielding will absorb and/or reflect EMI energy to both confine the EMI energy within a source device, and to insulate that device from EMI energy from other devices or source. Many electronic housings, however, are provided with access panels, hatches, doors or other closures, which both permit the outward radiation of such electromagnetic interference (EMI) energy, and allow EMI energy to enter and interfere with the enclosed electronics. Any gap between the metal surfaces abutting or mating with the closure affords an opportunity for the passage of EMI. Such gaps also break electrical ground conduction path of EMI energy along the surfaces of the enclosure to ground.

Conductive gasket shields incorporated into actual or potential housing gaps will absorb and/or reflect EMI energy to both confine the EMI energy within a source device and insulate that device from EMI energy from other devices or source, and will allow the continuation of a ground conduction path of EMI energy along the surfaces of the enclosure to ground. The present invention relates to a conductive gasket as may be used as such EMI shielding in electronic devices. For example, cards/cage type of equipment is popular, especially in the telecommunication industry. Each module within these frameworks is shielded by an EMI gasket mounted on the side of the module face plate.

### (2) Description of related art

It is known in the art to insert a shield between a source of EMI and a desired area of protection. Many such shields comprise a conductive housing, which is electrically grounded surrounding a foam core.

Various configurations of gaskets have been developed to close the gaps between components of the shield. These gaskets establish as continuous a conductive path as possible across any gap that may exist, for example, between cabinet components. A common gasket employs a flexible core enclosed in a woven fabric made at least in part with conductive fibers. Examples of such fabrics are disclosed in U.S. Pat. No. 4,684,762.

Another common gasket construction as disclosed, for example, in U.S. Pat. Nos. 4,857,668 and 5,597,979 has a flexible core enclosed in an electrically conductive sheath formed of a woven or non-woven fabric. The fabric is rendered conductive by an electroless plating process wherein the fabric is dipped in a silver nitrate bath to impregnate the fabric with silver. In an alternative process, the conductive material including silver or copper may be applied by sputter deposition. After impregnation or coating with silver, the fabric is coated with a non-corrosive material to prevent the oxidation of the silver surface. Suitable coating materials applied either by electroplating or sputter deposition include a pure metal such a nickel or tin, a metal alloy such as Inconel® or Nichrome® or a carbon compound.

In still another type of gasket, the conductive sheath comprises a polymeric film that is rendered conductive by the vapor deposition of a conductive metal onto a surface of the film as shown in U.S. Pat. No. 6,541,698.

United States Patent Application 20100258344 to Creasy, published October 14, 2010 discloses an electromagnetic interference shield which generally includes a resilient core member and an electrically conductive layer. An adhesive bonds the electrically conductive layer to the resilient core member. The adhesive may be halogen-free and flame retardant.

United States Patent Application Publication 20110105649 to Tadakatsu et al. published May 5, 2011 discloses a flame retardant resin composition that includes a thermoplastic resin and a flame retardant, the flame retardant being formed of phosphorated polysaccharide that is formed by attaching thiophosphoric acid ester or phosphoric acid ester to a side chain of natural polysaccharide.

United States Patent Application Publication 20110160372 to Youm published June 30, 2011, Thermoplastic Resin Composition with EMI Shielding Properties, discloses a thermoplastic resin composition comprising (A) a thermoplastic resin, and (B) a carbon nanofiber-metal composite including a plurality of laminated truncated, conic graphenes continuously coated with a metal, which purportedly can have excellent EMI shielding properties.

United States Patent Application Publication 20110067918 to Whu et al. published March 24, 2011, EMI Shielding Materials, discloses corrosion-resistant electromagnetic interference ("EMI") shielding material provided as an admixture of an elastomeric polymeric component and a filler component where the filler component is provided as glass or aluminum particles which are electroless-plated with a plating of a nickel-phosphorous alloy.

### BRIEF SUMMARY OF THE INVENTION

The present invention provides an improved EMI shielding gasket for stationary, portable and other electronic apparatus. In the present invention, a gasket having electromagnetic interference shielding properties is disposed between adjacent metal or other surfaces to block the entry or exit of electromagnetic radiation in the gaps between the adjacent surfaces, and to continue a ground conduction path of EMI energy long the surfaces of the enclosure to ground. More particularly, the present invention relates generally to halogen-free, flame retardant EMI shielding gaskets, comprising a halogen-free, flame retardant foam core clad in an abrasion resistant metal plated woven or non-woven fabric material, and where the completed gasket structure is halogen-free and fire retardant. The foam core provides the necessary resiliency and limited compression set, and the gasket is conductive. The gasket is made using a process layering the components to achieve the objectives. Thus, the present invention may be characterized in one aspect as a gasket having electromagnetic shielding properties for disposition between adjacent metal components comprising:
a) a resilient foam core;
b) a sheath surrounding the resilient foam core;
c) the sheath being conductive and abrasion resistant; and
d) lamellar adhesive and/or back-coating layer between the sheath and the core,
e) the structure being halogen-free, while maintaining flame-retardant properties.

The present invention is also directed to the method of manufacturing the improved EMI gasket. The gasket can be made in complex shapes and/or composite structures.

### BRIEF DESCRIPTION OF THE SEVERAL VIEWS OF THE DRAWINGS

For a fuller understanding of the nature and objects of the invention, reference should be had to the following detailed description taken in connection with the accompanying drawings:
FIG. 1 is a cross sectional view of an EMI gasket;
FIG. 2 is a cross sectional view of an EMI gasket with a pressure-sensitive adhesive;
FIG. 3 is a cross sectional view of an EMI gasket with a bump according to one embodiment of the present invention;
FIG. 4 is a cross sectional view of an EMI gasket with a plastic insert;
FIG. 5 is a cross sectional view of an EMI gasket with a plastic / metal clips;
FIG. 6 is a cross sectional view of an EMI gasket with an inner mini-plastic / metal clips;
FIG. 7 is a cross sectional view of an EMI gasket without a bump and its shielding effectiveness testing data;
FIG. 8 is a cross sectional view of an EMI gasket with a bump and its shielding effectiveness testing data;
FIG. 9 is a series of graphs showing the shielding effectiveness of a gasket according to the present invention;
FIGS. 10-11 are views of a gasket in accordance with Example 2;
FIG. 12 is a graph showing the shielding effectiveness of a gasket according to Example 2

The drawings will be described further in connection with the following Detailed Description of the Invention. The drawings are for the sole purpose of illustrating selected embodiments, and are not intended to describe all possible implementations or to limit the scope of the present disclosure. Corresponding reference numerals indicate corresponding parts throughout the several views of the drawings.

### DETAILED DESCRIPTION OF THE INVENTION

### Definitions

The below terms used in this disclosure are defined as follows:
"Electromagnetic interference" or "EMI" should be considered to generally include and refer to both electromagnetic interference (EMI) and radio frequency interference (RFI) emissions. The term "electromagnetic" should be considered to generally include and refer to both electromagnetic and radio frequency from external sources and internal sources. Accordingly, the term shielding (as used herein) generally includes and refers to both EMI shielding and RFI shielding, for example, to prevent (or at least reduce) ingress and egress of EMI and RFI relative to a shielding device in which electronic equipment is disposed.
"Halogen-free" is defined in accordance with the International Electrotechnical Commission (IEC) (see IEC 61249-2-21), and the Japan Electronics Packaging and Circuits Association (JPCA), which means that the product contain no more than 900 ppm bromine, 900 ppm chlorine, and 1,500 ppm of bromine and chlorine combined.
"Electrically-conductive" means that the web may be rendered conductive, such as, for example, to a surface resistivity of about 0.1 Ω/sq. or less, by reason of its being constructed of electrically-conductive wire, monofilaments, yarns or other fibers or, alternatively, by reason of a treatment such as a plating or sputtering being applied to non-conductive fibers to provide an electrically-conductive layer thereon.

In describing the structure, of the fiber or polymeric film, the reverse side is in contact with the core and the obverse side is outward facing.

### Description

The present invention will now be described in the following detailed description of the invention, in which some, but not all embodiments of the invention are described. The previously-stated objectives and other features and advantages of the present invention, will become readily apparent from this detailed description when taken in connection with the accompanying drawings and the ordinary skill in the art. However, the detailed description is not intended to limit the scope of the invention as set forth by each particular claim. The various aspects of the system of the invention detailed below may be embodied in many different forms and should not be construed as limited to the embodiments set forth below.

It is also to be understood that support for the various applications or portions thereof thereby, can appear throughout the text and/or drawings at one or more locations, irrespective of the section headings. At least certain portions of the text of this disclosure (including claims, detailed description, and/or drawings) can support various different claim groupings and/or various different applications. Thus, the detailed description may include section headings that generally track various different concepts associated with claims or general concepts contained in this disclosure for sake of convenience and understanding.

It is also noted that a person skilled in the art will also appreciate that development of any actual implementation, as in any engineering or design project, requires numerous implementation-specific decisions to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

### General Structure

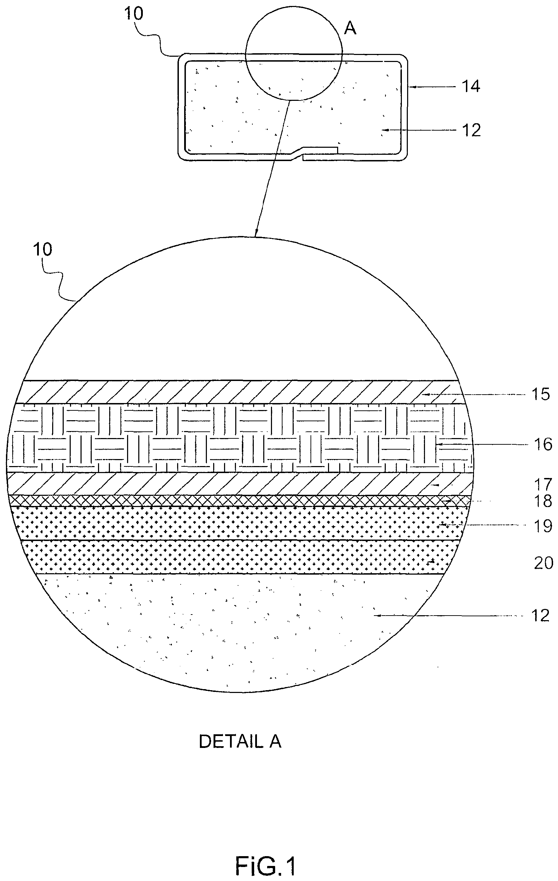

Referring to the drawings, FIG. 1 shows an embodiment of the flame-retardant conductive gasket of the present invention generally indicated at 10. It will be recognized that the thicknesses of the various components in FIG. 1 are not to scale but are shown greatly enlarged for clarity. For example the gasket itself may range from 0.01 to 1.0 inches (0.254 mm to 25.4 mm) thick with the sheath 14 being no more than about 0.008 inches (0.203 mm) thick. It should be appreciated that the shape of the cross section of the gasket is shown for purposes of illustration only. The gaskets of the present invention can be formed in a wide-variety of shapes and profiles.

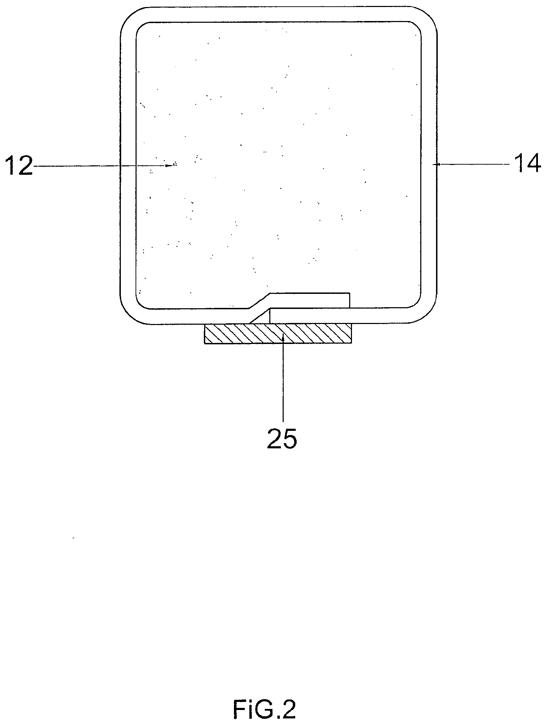

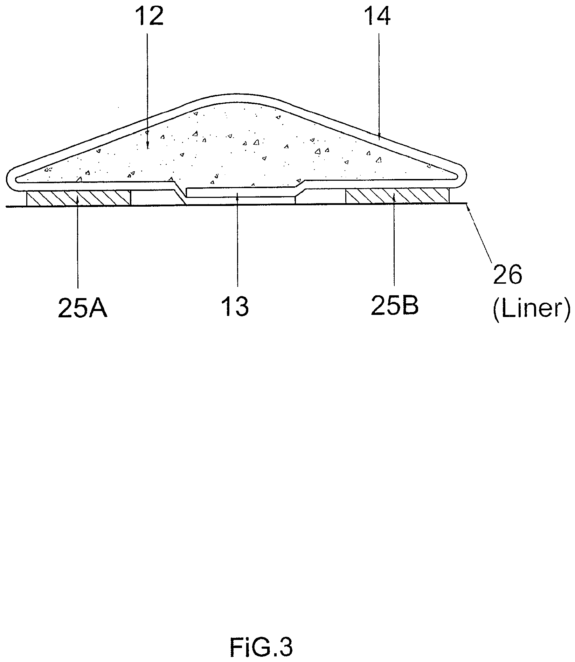

The gasket includes a foam core 12. Surrounding the core 12 is a conductive sheath or cladding 14. As shown in FIG. 3, gasket 10 may comprise a bump 13 created in the structure. FIG. 2 provides an alternate example of an EMI shielding gasket which does not form part of the invention. As shown in FIG. 2, a double-sided tape or other layer, 25, of a pressure-sensitive adhesive (PSA) or other adhesive may be provided on one or more sides of the gasket for attaching the gasket 10 to an electronic component. As shown in FIG. 3, such PSA or other adhesive layer may be on both sides of a bump created in the structure, with both tape layers covered by a removable release liner 26 to allow for an easy peel-and-pick placement of the gasket 10.

### Foam

Foam core 12 comprises a foamed polymeric material. The polymeric materials may be selected on the basis of one or more of operating temperature, compression set, force defection, flammability or other chemical or physical properties. Preferably, foam core 12 is resilient and compliant over a range of temperatures and which preferably exhibits good compression set characteristics such that the material will "spring bac k" after repeated compression and decompression and even after long periods of compression. The gasket made from the compressible foam can be compressed by external applied force or mechanical load by 0-1% in the axis of applied force (just in contact). Preferably, the gasket can be compressed by external applied force or mechanical load by at least 50%. More preferably, the gasket can be compressed by external applied force or mechanical load by at least 98% without inherent material failure such as cracking or rupture.

As is well known to persons having ordinary skill in the art, foam generally has one of two types of structures: open-celled or close-celled. Either type can be employed in the present invention. The foamed polymeric material may be a polyolefin such as polypropylene or polyethylene, ethylene-propylene-diene terpolymer (EPDM), polypropylene-EPDM blend, polyphenylene sulfide, polyalkylene terephthalate such as polyethylene terephthalate or polybutylene terephthalate, butadiene, styrene-butadiene, nitrile, neoprene, urethane, silicone, polyamide, and the like, and copolymer blends or combinations thereof. Such material specifically may be selected as depending upon one or more of operating temperature, compression set, force defection, flammability, or other chemical or physical properties.

If weatherability and durability are important, it is helpful if the polymer or polymers do not contain functional groups which can be hydrolyzed.

Specific polymers for use in the manufacture of the foams include polyurethane foams. In one embodiment, the foam core 12 is an open-celled polyurethane foam in a high-resiliency formula. In a preferred embodiment the compressive set of the foam is 1% at ambient temperature and less than 5% at 70°C (158° F) when compresses 50% for 22 hours.

In one embodiment, the flame retardant foam 12 comprises organic foaming agent, low density polyethylene and other flame retardant filler, in addition to base resin made of polyethylene base foam. In another embodiment, the flame retardant foam comprises organic foaming agent with synthetic or natural rubber, flame retardant filler in addition to a base resin made of Rubber Sponge, EPDM or EVA (ethylene vinyl acetate)

In another embodiment, the flame retardant foam 12 may comprise 20 to 75 parts by weight of expandable graphite, 14 to 50 parts by weight of aluminum hydroxide, and 3 to 25 parts by weight of ammonium phosphate, based on 100 parts by weight as a basic mixing ratio for synthesis of polyurethane (foam density: 100 to 150 kg/m3).

Polyurethane foams are formed from precursor compositions comprising an organic isocyanate component, an active hydrogen-containing component reactive with the isocyanate component, a surfactant, a catalyst and other additives. The process of forming the foam can use chemical or physical blowing agents, or the foam can be mechanically frothed. For example, one process of forming the foam comprises substantially and uniformly dispersing inert gas throughout a mixture of the above-described composition by mechanical beating of the mixture to form a heat curable froth that is substantially structurally and chemically stable, but workable at ambient conditions; and curing the froth to form a cured foam. In one embodiment, a physical blowing agent is introduced into the froth to further reduce foam density during the crosslinking process. In another embodiment, the polyurethane foam is formed from the reactive composition using only physical or chemical blowing agents, without the use of any mechanical frothing. Specific formulations for rendering polyurethane foams are known in the art. It is critical, however, that the foam product be halogen-free and fire retardant.

One mixing ratio for synthesis of flame-retardant, halogen-free polyurethane foam is the mixing ratio that is essentially required to prepare polyurethane foam, i.e., 5 to 20 parts by weight of toluene diisocyanate, 2 to 5 parts by weight of water, 0.5 to 2.5 parts by weight of silicone surfactant, 0.1 to 1 parts by weight of an amine catalyst, 0.5 parts by weight of a tin catalyst, and 20 to 40 parts by weight of flame retardant filler and 10 to 30 parts by weight of an additive, based on 100 parts by weight of non-halogenated polyol.

Another embodiment of flame retardant halogen-free polyurethane foam may include 100 parts w/w non-halogenated polyurethane resin, 5-30 parts w/w aluminum hydroxide, 5-30 parts w/w ammonium polyphosphate, 5-30 parts w/w graphite, 5-20 parts w/w foaming agent, and, if necessary, pentaerythritol.

However, the present invention is not limited to this mixing ratio. The mixing ratio and the additives, etc., may be changed according to properties of the base urethane foam as is known in the art.

### Antimicrobial Halogen-Free Fire-Retardant Foam

In some embodiments, it is preferred that the foam resist mold or other microbial contamination. Polyurethanes are step-growth polymers generated from the reaction of isocyanate and hydroxyl functional groups. In addition to reaction with hydroxyl groups, the isocyanate group can also react with water, carboxylic acids, and amines to generate an amine, amide, and urea, respectively. Antimicrobial polyurethane polymers can be utilized in the invention. For example, the foam core 12 may be derived from methylenediphenyl diisocyanate (MDI) chain extended with 1,4-butanediol and polytetramethylene glycol (PTMO). Antimicrobial character can be obtained through sulfonation as well as phosphonation. Zwitterionic, phosphonized and quaternized versions can be made by reacting novel chain extenders with poly(tetramethylene oxide) and methylene diphenyl diisocyanate. It has been reported that tetramethylene glycol-4,4'-diphenylmethane diisocyanate prepolymers extended with diethylenetriamine, reacted with epichlorohydrin and quaternized result in quaternary ammonium polyurethane/polyurea (H.-H. Wang, M.-S. Lin; J. Polym. Res.; Vol. 5, (1998), p. 177) and quaternized N,N-bis(2-hydroxyethyl)isonicotinamide as a chain extender in poly(tetramethylene oxide)-based polyurethane block copolymers (J.A. Grapski, S.L. Cooper; Biomaterials; Vol. 22, (2001), p. 2239) foams that show some antimicrobial activity. US Patent 7,459,167 reports that antimicrobial activity was imparted to a polyurethane using free radical polymerization of a quaternary ammonium methacrylate, and particularly that polymeric compositions that include polyurethane polymers derived from a polyisocyanate compound and a polyactive hydrogen compound, where the polyurethane compound is at least partially endcapped with a group including at least one antimicrobial quaternary ammonium compound, is capable of forming a self-supporting film kills or prevents the growth of microorganisms such as bacteria, mold, mildew, algae fungi and the like.

### Foam Filler

The foam core 12 incorporates non-halogenated fire retardants such as aluminum trihydrate, magnesium hydroxide, metal oxides and salts, intercalated graphite particles, phosphate esters, phosphates, glass, silica, which may be fumed or crystalline, silicates, mica, ceramics, and glass or polymeric microspheres.

The thermoplastic resin composition can also be impregnated with a filler which has independent EMI shielding ability. Examples of filler having EMI shielding ability include metallic fillers, which can include various types and forms of metal powder, such as carbon fiber, carbon nanotubes, carbon nanofibers, and the like, provided that the fillers form a network structure. A carbon nanofiber-metal composite, known in the art, readily forms a network structure. The network capability will increase as the amount of impregnated fillers increases, although increasing filler will adversely affect the processability and mechanical strength of the final product. If the filler is properly balanced to minimize the total weight of the specific composition, the metallic fillers can increase electric conductivity and thus EMI reflection and absorption by magnetic permeability, while limiting any adverse consequences by minimizing the amount of the filler. In exemplary embodiments of the present invention, the aspect ratio (Length/Diameter) of the carbon nanofiber-metal composite can be more than about 10, for example about 10 to about 200.

The carbon nanofiber-metal composite is made by treating a carbon nanofiber with an acid solution to activate the surface of the carbon nanofiber; washing the surface-activated carbon nanofiber and then digesting the surface-activated carbon nanofiber with an acid solution in which a catalyst is dispersed to distribute the catalyst onto the surface of the carbon nanofiber; rewashing the carbon nanofiber on which the catalyst is distributed; and electroless plating the carbon nanofiber with a metal solution to form a metal coating layer.

Other suitable materials for the electrically-conductive component include: noble and non-noble metals such as nickel, copper, tin, aluminum, and nickel; and noble or non-noble metal plated non-metals such as silver or nickel-plated graphite, glass, ceramics, plastics, elastomers, or mica; and mixtures thereof. The component may be incorporated into the foam in "particulate" form, and may be of any form that is conventionally involved in the manufacture or formulation of conductive materials, including hollow or solid microspheres, elastomeric balloons, flakes, platelets, fibers, rods, irregularly-shaped particles, or a mixture thereof.

Alternatively, the electrically-conductive component may be incorporated into the foam material as a web such as in the manner described in U.S. Pat. No. 7,022,405. Such web may be oriented or random, and may be formed of a blend of one or more conductive fibers to render the web electrically conductive, and one or more polyester, polyolefin, polyamide, or other thermoplastic polymer or co-polymer fibers which may be softenable or meltable to heat set the web.

### Other

The thermoplastic resin composition according to the present invention can optionally further include one or more additives selected from the group consisting of antibiotic agents, release agents, heat stabilizers, antioxidants, light stabilizers, compatibilizers, dyes, inorganic fillers, surfactants, nucleating agents, coupling agents, fillers, plasticizers, impact modifiers, blending agents, coloring agents, stabilizers, lubricants, antistatic agents, pigments, and the like, and combinations thereof.

### Sheath

The sheath or cladding 14 is a laminate comprising a substrate 15, which can be a polymeric material such as nylon, polyester or acrylic formed as a woven or non-woven fabric. Other flammable or non-flammable fabrics may also be used. In one embodiment, a woven or non-woven polyester fabric. The substrate may range in thickness from 0.25 mils to 8 mils (0.006 mm to 0.203 mm). The substrate may be a woven or non-woven fabric and preferably is a nonporous polymeric film such as nylon or the like.

Sheath 14 is rendered conductive by metal plating. The conductive layer of the sheath can be any highly conductive metal such as copper, nickel, gold, silver or platinum with silver being preferred. An alloy may be used. The conductive layer can be rendered by an electroless plating process wherein the substrate 15 is dipped in a plating bath to impregnate the fabric or other substrate with a metal. The thickness of the coating layer can be adjusted by changing the concentration of the metal solution. In exemplary embodiments, the concentration of the metal source in the metal solution can be about 0.01 to about 1 M, for example about 0.05 to about 0.1 M. In an alternative process, the conductive material, including silver or copper or nickel, may be applied by sputter deposition.

In many applications, it is likely that the conductive surface of the fabric will contact an adjacent metal surface such as a computer housing. The accelerated oxidation of the conductive metal layer on the fabric by galvanic action is a concern. Oxidation or corrosion of the conductive metal will decrease the surface conductivity of the fabric and compromise its effectiveness as an EMI shield. Accordingly, a surface layer is deposited over the conductive layer for abrasion resistance, and to prevent oxidation of the silver layer. The surface layer may be carbon, a pure metal such as nickel, aluminum, iron, tin or zirconium or a metal alloy such as an iron-chrome-nickel alloy, a nickel-chrome alloy, Monel® (a series of nickel alloys, primarily composed of nickel [up to 67%] and copper, with some iron and other trace elements), or a carbon compound will provide protection against galvanic action and be abrasion resistant without compromising the conductivity of the surface, which adheres to the conductive metal layer 15 and is corrosion resistant. For example, after impregnation or coating with a metal, the substrate is coated with a non-corrosive material to prevent the oxidation of the metal surface.
Suitable coating materials applied either by electroplating or sputter deposition include a pure metal such a nickel or tin, a metal alloy such as Monel®, Inconel® or Nichrome® or a carbon compound.

To reduce costs and facilitate fabrication, the layers of the metalized layer may be deposited in sequence by vapor deposition.

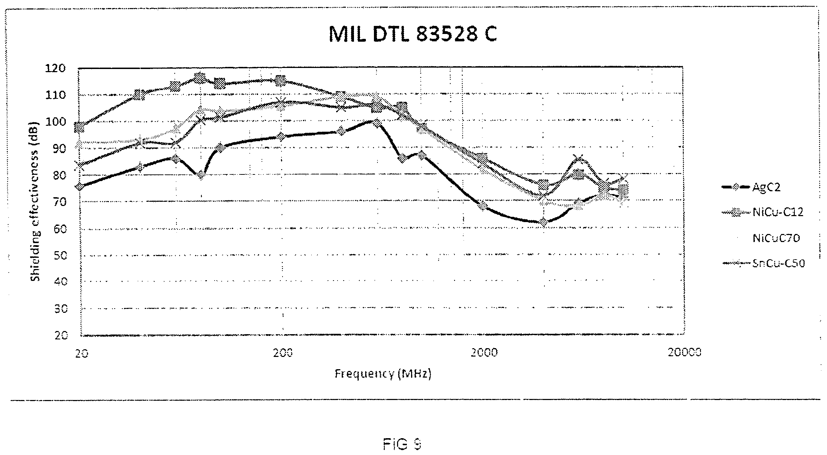

The sheath may be that utilized in gaskets commercialized by Schlegel Electronic Materials. For examples, the sheaths are including as follows and the shielding performance testing results was shown on FIG 9.

C12: comprises a layer of copper topped by a layer of nickel, plated to a polyester woven substrate and sealed:
Surface Resistivity (ASTM F390 modified): ≤0.028Ω/sq.
Shielding performance per MIL- DTL 83528C in frequencies of 20 MHz to 10 GHz: 97.4 dB (average). (Note: Gasket geometry and application determine actual shielding effectiveness).
Contact Resistance: (SEM LP-3001): < 0.08 Ω-inch at 1 Kg load/inch
Abrasion Resistance: (ASTM D3886): No change in surface resistivity: 1,000,000 cycles.

C70: comprises a layer of copper topped by a layer of nickel, plated to a polyester rip-stop fabric and sealed:
Surface Resistivity (ASTM F390 modified): ≤0.066 Ω/sq.
Shielding performance per MIL- DTL -83528C in frequencies of 20 MHz to 10 GHz: 96dB (average). (Note: Gasket geometry and application determine actual shielding effectiveness).
Contact Resistance: (SEM LP-3001): < 0.11 Ω-inch at 1 Kg load/inch
Abrasion Resistance: (ASTM D3886): No change in surface resistivity: 800,000 cycles.

C2: comprises a layer of silver topped by a layer of carbon, plated to a nylon rip-stop fabric and sealed:
Surface Resistivity (ASTM F390 modified): ≤0.5 Ω/sq.
Shielding performance per MIL- DTL -83528C in frequencies of 20 MHz to 10 GHz: 95 dB (average). (Note: Gasket geometry and application determine actual shielding effectiveness).
Contact Resistance: (SEM LP-3001): < 1.00 Ω-inch at 1 Kg load/inch
Abrasion Resistance: (ASTM D3886): No change in surface resistivity: 800,000 cycles.

C50: comprises a layer of copper topped by a layer of tin, plated to a nylon plain weave fabric and sealed:
Surface Resistivity (ASTM F390 modified): ≤0.016 Ω/sq.
Shielding performance per MIL- DTL -83528C in frequencies of 20 MHz to 10 GHz: 95.3 dB (average). (Note: Gasket geometry and application determine actual shielding effectiveness).
Contact Resistance: (SEM LP-3001): < 0.09 Ω-inch at 1 Kg load/inch
Abrasion Resistance: (ASTM D3884): No change in surface resistivity: 1,000 cycles.

C22: comprises a layer of copper topped by a layer of nickel, black pigment top coating which plated on to a polyester woven substrate and sealed:
Surface Resistivity (ASTM F390 modified): ≤0.08 Ω/sq.
Shielding performance per MIL- DTL -83528C in frequencies of 20 MHz to 10 GHz: 95.76 dB (average). (Note: Gasket geometry and application determine actual shielding effectiveness).
Contact Resistance: (SEM LP-3001): < 0.2 Ω-inch at 1 Kg load/inch
Abrasion Resistance: (ASTM D3884): No change in surface resistivity: 1,000 cycles.

### Coatings

In the preferred embodiment, protective coating layers 15, 17, are applied to the conductive sheath 16 on both the obverse side reverse side for abrasion resistance, corrosion resistance and galvanic compatibility. Even though the coating materials for coating layers 15, 17 are non-conductive, a thin layer will provide the desired protection without materially decreasing the conductivity of the metal layer beneath. The preferred protective coating layers 15, 17 comprise a polyacrylic sealer, such as an acrylic latex emulsion, and may be an emulsion-polymerized acrylic latex. The acylic latex may also be synthesized by copolymerizing general acrylates with phosphorus monomer in the presence of phosphorus emulsifier with the amount of phosphorus monomer ranging from 4 to 6 w/w. The layer is coated to a wet thickness of about 4 mils (0.1 mm), and then cured to a dried coating or film thickness of between about 1-4 mils (0.025-0.10 mm) on the top surface, recognizing that some of the coating will penetrate the sheath.

Coated onto the reverse side of the coated fabric are flame-retardant coating 18 which is preferably a very low viscosity saturated polyester resin or a saturated polyurethane resin.
Coating 18 may be an organic material such as a thermoplastic resin and a thermosetting resin, such as, for example, an acrylic, polyurethane, polyester or polycarbonate resin among others. As the thermoplastic resin, for example, low-density polyethylene, medium-density polyethylene, high-density polyethylene, polypropylene, polystyrene, polyurethane, polyvinyl acetate, polyvinyl chloride, polyvinylidene chloride, polyacrylic acid, polyacrylate, polyacrylic ester, polybutadiene, polyisoprene, ethylene propylene rubber, butyl rubber, acrylonitrile-butadiene-styrene copolymer, acrylonitrile-ethylene propylene rubber-styrene copolymer, ethylene-vinyl acetate copolymer, etc. may be cited. These thermoplastic resins may be used either singly or in the form of a combination of two or more members. Coating layer 18 is very low viscosity to enable good spreadability of the coating and coverage of all interstices in the substrate.

A preferred embodiment of the present invention is characterized in that the reverse surface of the above coated fabric is further back-coated with a first halogen-free, flame retardancy-imparting back-coat 19. Back-coat 19 preferably comprises a thermoplastic resin or a thermosetting resin, and a fire-retardancy-imparting material. First back-coat 19 thermoplastic resin will have an average molecular weight in the range of 1,000 to 500,000. The back-coat 19 thermosetting resin will have an average molecular weight between cross-linkages in the range of 50 to 50,000. In both cases, it will be difficult to sufficiently incorporate a flame-retardant material if the molecular weight is too low, while higher molecular weight materials adversely affect processability. The thermosetting resin may be, for example, a cross-linked polyurethane, a cross-linked polyester, a cross-linked epoxy resin, a cross-linked acrylic resin, a cross-linked copolymerized nylon resin, etc. may be cited. These thermosetting resins may be used either singly or in the form of a combination of two or more members.

A preferred embodiment of first back-coat 19 is a cross-linked cured polyurethane layer The material is halogen-free and has good durability. The viscosity of the first back-coat material 19 is higher than that of the coating 18, but is still relatively low viscosity to enable good spreadability of the coating..

First back-coat 19 may comprise a mixture of a polymer resin and expandable graphite. The material can be prepared by mixing about 5-20 parts w/w of an expandable graphite to about 80-95 parts w/w of saturated polymer resin. Mixing of expandable graphite flakes into the polymer resin may be carried out at about 50°C using a high shear mixer to ensure uniform dispersion.

In another embodiment, first back-coat 19 may comprise a polyurethane resin, expandable graphite, and a phosphorus-based composition such as alumina trihydrate, a polyphosphoric acid salt and tricresylphosphate, or a mixture thereof.

In one embodiment, the coating generally comprises (A) a thermoplastic resin, (B) liquid phosphate, (C) ammonium polyphosphates powder, and (D) graphite powder. Examples of (A) the thermoplastic resin include without limitation polyphenylene sulfide; polyamide; polyalkylene terephthalate such as polyethylene terephthalate or polybutylene terephthalate; polyacetal; polyimide; polyphenylene oxide; polysulfone; polyamide imide; polyether sulfone; liquid crystal polymer; polyether ketone; polyether imide; polyolefin such as polypropylene or polyethylene; acrylonitrile-butadiene-styrene; polystyrene; syndiotactic polystyrene, and the like,
and combinations thereof. In one exemplary embodiments of the present invention, the thermoplastic resin composition can include (A) about 50% by weight of the thermoplastic resin, (B) 12-18% by weight of the liquid phosphate (C) 8-12 % by weight of the ammonium polyphosphates powder, and (D) 25-35% by weight of the graphite powder.

In another embodiment, first back-coat 19 may comprise a saturated polyurethane resin, expandable graphite, and a phosphorus-based composition such as ammonium polyphosphate, triphenyl phosphate, halogen-free polymeric phosphorus ester, or a mixture thereof.

In one embodiment, first back-coat 19 may comprise the above components in the ratio:
40-50% - Saturated Polyurethane Resin
20-30% - Phosphate-containing non-halogenated fire-retardant agent
20-30% - Expandable graphite

First back-coat 19 can be applied as a liquid to the surface of the fabric by dipping, spraying or wiping, where it forms a thin film when it is dried, cured or polymerized. After application, the fire-retardant first back-coat 19 is allowed to dry, cure or polymerize to form a thin fire-retardant layer 19 that bonds with the coated substrate fabric and the foam core 12.

If foam core 12 is foamed-in-place, a second back-coat 20 can be applied to prevent chemical bleeding during the foaming process, and can be the same as first back-coat 19. If a preformed foam core is utilized, it is preferable that second back-coat 20 comprise a hotmelt adhesive without inclusion of any fire-retardant materials.

### PSA

To ease mounting the gasket, a double-sided pressure sensitive adhesive (PSA) 25 is preferably used on the base of the gasket. In the preferred embodiment the adhesive is non-conductive. Generally, non-conducting adhesives provide more favorable peeling and shearing strength characteristics compared to the conductive adhesive. For example, conductive particles tend to reduce the adhesion characteristics of the PSA.

The standard PSA can be supplemented with or combined with a continuous delaminatable release liner 26.

In some embodiments, as shown in FIG. 3, gasket 10 will benefit from two spaced-apart rows of pressure sensitive adhesive 25A and 25B. In such embodiments, it is preferred that the assembly include a single spanning both rows 25A and 25B. The single wide liner renders peeling liner more efficient, by eliminating multiple patches of release liner and replacing them with single wide release liner.

In one aspect of the present invention, an exemplary adhesive tape assembly comprises a double-sided adhesive tape comprising front and back adhesive sides, each of the adhesive sides comprising a pressure sensitive adhesive; and a delaminatable release liner in contact with, bonded to and readily removable from at least one of the adhesive sides.

The double-row PSA can be applied to gasket 10 using a preformed adhesive tape roll comprising two rows of PSA spaced apart, with a continuous double-wide release liner already laminated to both rows of PSA. Alternatively, dual rows of PSA may be applied sequentially or simultaneously from separate rows, and a single continuous double-wide release liner 26 spanning both rows 25A and 25B can be applied to the rows of PSA.

Release liner 26 may be composed of polyolefins, silicones, fluorocarbons, low adhesive backsizes (e.g., those made for polyureas, polyurethanes, polyacrylates, etc.), perfluoroether, and combinations thereof. General knowledge in the art can be used to help in the selection of the release material for a certain pressure- sensitive adhesive. For example, a polyacrylate PSA can be used with release materials made from polyolefins, silicones, and fluorocarbons. A tackified block copolymer PSA can be used with polyurea or polyurethane backsizes as well as silicones and fluorocarbons. In embodiments with a dual row of PSA 25A and 25B, it is desirable that the continuous wide release liner 26 be readily removable, and the releasability is enhanced if release liner 26 comprises at least one of a silicone and a fluorocarbon.

The present invention contemplates the use of any suitable PSA in the practice of the invention. PSAs are generally known in the art and include, but are not limited to, polyacrylate polymers and copolymers, polyurethanes, ethylene vinyl acetate copolymers, natural rubber, block copolymers, and the like. The adhesives may include tac kifiers and plasticizers as needed to provide the desired adhesive and modulus properties for the end use of the tape. Shearing strength is especially important in Flat-D shape card cage gasket application.

The PSA may be that offered by 3M as High peeling strength tape 3M950, High shear strength tape 3M9485 and High shear strength tape with carrier 3M9495.

### Profiles

Profiles can be cut to specified lengths, kiss-cut release liner or mitered to form frame configurations. The gasket can be in the following profiles and forms, all terms being well-recognized in the art: square, rectangle, D-shape, Flat D-shape Bell-shape, P-shape, L-shape, T-shape, , double D-shape, U-shape, C-fold, wedge, knife-edge and composite profile with plastic / metal clips including mini-clips profile, D-clip profiles with the foam and clips being chemically bonded, and variations thereof. The profile shape can be designed to accord with the application, and the variations are limited solely by the capability of the foaming process. The gasket dimensions can range to occupy any space, but typically will range from 0.020 inches X 0.157 inches (0.5 mm X 4 mm) to 0.630 inches x 1.0 inches (16 mm X 25 mm)

### Bump

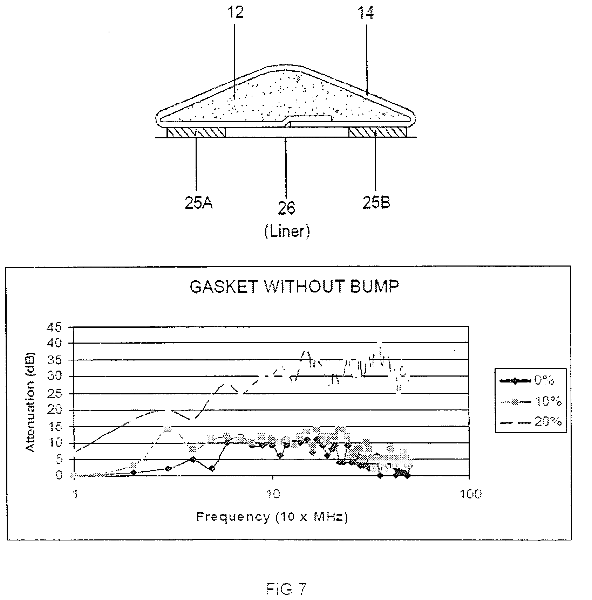

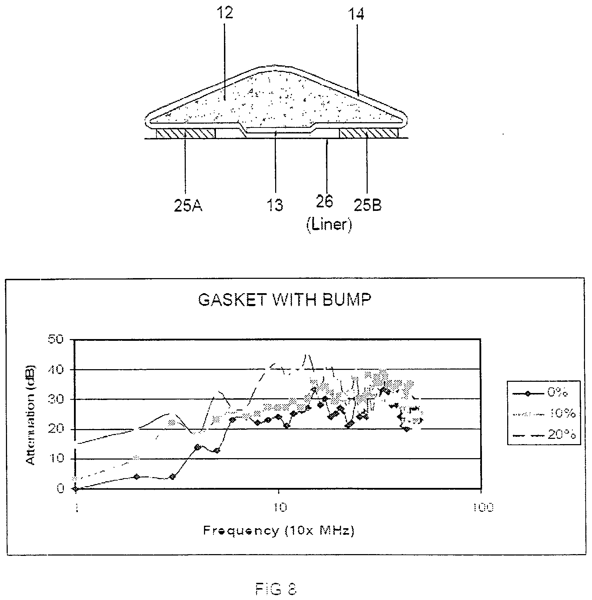

In one embodiment, the gaskets of the present invention incorporate a center base-bump 13. The base-bump design enhances continuous contact when PSA is utilized and minimal compression is exerted on the gasket. The PSA is approximately 0.008 inches to 0.012 inches (0.2 to 0.3 mm) thick, and including such PSA in gasket construction creates the gap at the surface of the gasket where the PSA is applied. Testing indicates that shielding can be substantially reduced in the event that a gasket is compressed less than 10% of the height of gasket in the axis of applied force, with EM waves leaking through the gap created by the PSA. FIG 7 discloses the shielding effectiveness upon 20% compression. FIG 8 demonstrates that in the preferred gasket embodiment comprising the bump, where the thickness of the bump corresponds to the approximately the thickness of the PSA, the gasket is already effective at almost zero compression.

### Insert and Clips

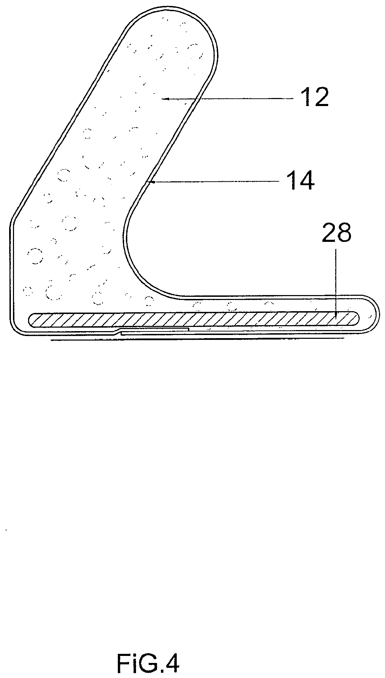

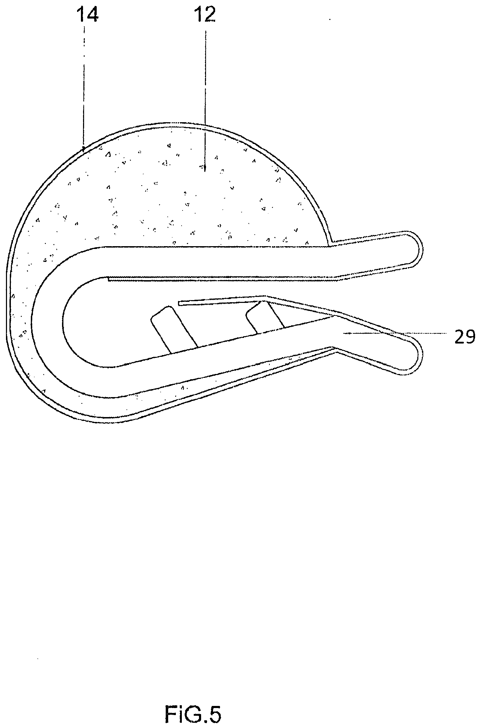

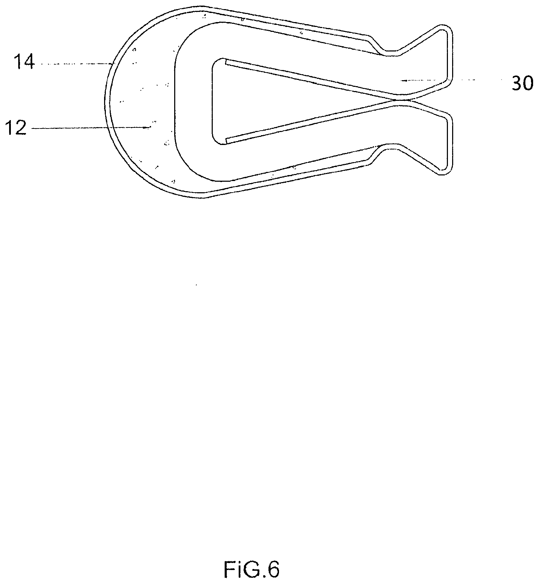

In one embodiment, the gaskets of the present invention incorporate a composite structure. FIGS. 4, 5 and 6 provide examples of EMI shielding gaskets which do not form part of the invention. As illustrated in FIG. 4, gasket 10 may incorporate insert 28. Insert 28 is relatively rigid and is configured to enhance the support of the gasket. In another embodiment, as shown in FIG 5, insert 29, which is preferably rigid, can be incorporated to permit the clipping of gasket 10. In yet another embodiment, shown in FIG 6, clip 30 forms a substrate upon foam core 12 is foamed. The resulting structure of Figure 6, with clip 30 and foam 12 chemically bonded, allows especially strong clipping of gasket 10. A person skilled in the art will recognize that the structures shown in Figures 4-6 allow many variations, and gaskets may be produced in various composite profiles, using plastic and/or metal clips. The profiles can be in the form of mini-clips profile, D-clip profiles, T shape, C-fold profile and the like, depending to a specific application. The resulting structures enhance shielding coverage and performance for various applications compared to attaching a clip to a gasket.

### Manufacture

The foam core 12 of the present invention can be molded by conventional methods. Exemplary molding methods may be, but are not limited to, extrusion, injection, or casting molding, and may be easily carried out by a person with ordinary skill in the art.

The foam core 12 can be laminated to sheath 14 in a relatively continuous process, whereby a roll of the substrate material is unrolled in a forward direction from a continuous reel. The metallized substrate comprising metallized substrate 16 and protective coatings 15, 17 may be pre-made, or may be purchased from available sources.

Where the gasket can be prepared by a wrapping process, the foam is prepared by a standard process known in the art utilizing a catalyst, non-halogen fire-retardant filler, polyol and blowing agent. The formed core is then slit and cut specific sizes and pre-shaped, such as the D or Bell shapes. Concurrently, the coated substrate is processed to apply a thin film of saturated polyurethane resin 18, and thereafter cured. First back-coat 19 is then applied. If pre-formed foam is used, a hotmelt adhesive is applied as layer 20 but without the fire-retardant fillers. The foam core in its solid state pre-heated and substrate fabric are directed into the cavity of a mold heated to about 200° C. whereby the mold wraps the foam core in the cladding sheath. Downstream of the applicator, the pre-made foam core is pressed against the adhesive to form the laminate. The foregoing lamination process is merely illustrative.

The gasket may also be formed by the continuous foaming process. In the foam-in-place embodiment, second back-coat 20 is applied atop first back coat 19, and is followed by the foam core ingredients. The formulation including catalyst, non-halogen fire-retardant filler, polyol and blowing agent are mixed. The mixing ratio can be adjusted in the foaming machine to control the foam hardness, foam density, uniformity of foam cell, resilient properties and fire retardant level, as is known in the art. The foam ingredients in a liquid state will be poured on the coated fabric fitted into the mold with the help of folder plate / guide, and directed for about 7-10 minutes in an oven. The finished products will formed in the same shape as the mold profile at output. Different profile shapes are extruded by a mold so that any profile or shape is possible. In addition, the clips or insert 28, which may be a polycarbonate, polypropylene or metal including stainless steel, is placed into the mold to allow the insert to be formed in place with the foam. Further, the foam may be foamed unto inserts 29 and 30, to form a foamed-in-place clipping structure such as illustrated in Figures 5 and 6.

The foam-in-place technique described above is relatively faster than the wrapping process, with the foaming process operating at about 10 - 45 meters per minute, while the wrapping process operates significantly slower, depending on the profile and shape of the gasket. In addition, there is chemical bonding between foam 14 and sheath 12 of the gasket made by continuous foaming technique which is materially stronger compared to the interface between the foam and sheath produced in accordance with the wrapping technique. Further, the foaming technique generally enhances the resilience of gasket 10, compared to the resilience characteristics of gasket 10 made using a wrapping techniques. The increased resilience is particularly pronounced when the structure are of an irregular shape profile such as C-fold, U-shape, P-shape, L-shape, T-shape, double D-shape, Bell-shape, wedge, knife-edge etc.

The invention may be better understood by reference to the following examples, and which are intended for the purpose of illustration and are not to be construed as in any way limiting the scope of the present invention, which is defined in the claims appended hereto.

### EXAMPLES

### Example 1

A gasket comprising the invention is made by a foam-in-place process as described above. The sheath is an acrylic-sealed NiCu metallized Ripstop polyester fabric, and further sealed with a saturated polyurethane resin 18. The first and second back coats 19, 20 comprise:
40-50% - Saturated Polyurethane Resin
20-30% - Phosphate containing fire-retardant agent
20-30% - Expandable graphite
The foam ingredients are:
50-60% - Polyoxyalkylene Polyol
8-18% - Isocyanate curing agent
10-20% - Phosphate containing fire-retardant agent
0-10% - Aluminum Trihydrate
10-20% - Expandable graphite
2-5% - Additives

The gasket demonstrates the following compression set characteristics:
Temperature:70°C , 50% compression of free height for period of 22 hours

| Sample | Gasket | | | | | | |
|---|---|---|---|---|---|---|---|
| Before | 6.47 | 6.47 | 6.45 | 6.41 | 6.44 | 6.44 | 6.37 |
| After | 6.27 | 6.16 | 6.19 | 6.18 | 6.22 | 6.08 | 6.14 |
| | 0.0309 | 0.0479 | 0.0403 | 0.0359 | 0.0342 | 0.0559 | 0.0361 |
| Compression set | 3.09% | 4.79% | 4.03% | 3.59% | 3.42% | 5.59% | 3.61% |
| Average | 4.02% | | | | | | |

### Physical Performance:

The extremely low compression force allows the use of lighter weight materials with less fastening and hinge hardware. The gaskets find use in enclosures for computers, including servers, desktops and laptops, internal/external hard drives, telecommunications equipment and devices, liquid crystal displays (LCDs), plasma display panels (PDPs), printers, set-top boxes, digital cameras and medical equipment

The gasket of the present invention were subjected to a flammability test at Underwriters Laboratories using the test procedure for a vertical burn of very thin materials (VTM). The UL vertical burn test is a standard test more fully described in UL publication titled "Test for Flammability of Plastic Materials for Parts in Devices and Appliances" which is incorporated herein by reference. The UL publication may be consulted for details of the test procedure. However, for purposes of the present invention it is sufficient to say that in the Thin Material Vertical Burning Test, the test specimens are cut to a size of 125 ± 5 mm length x 13.0 ± 0.5 mm width x specific testing specimens thickness. The specimen is suspended so its longitudinal axis is vertical. A controlled fire is applied to the middle point of the bottom edge of the test specimen. After about ten seconds, the fire is withdrawn (dropped vertically from its initial position) at a rate of about 300 mm/sec to a distance of about 150 mm away from the specimen. Simultaneously, a timing device commences the measurement of the Afterfire Timei. "Afterfire Time" is defined as the time a material continues to fire, under specified conditions, after the ignition source has been removed. When the specimen has stopped flaming, the burner is placed about 10 mm from the specimen for another ten seconds and again withdrawn and the Afterfire Time measured a second time₂ and the Afterglow Time₃ also is measured. "Afterglow Time" is defined as the time a material continues to glow under specified test conditions after the ignition source has been removed and/or the cessation of flaming. For a rating of zero, both t₁ and t₂ must be less than ten seconds and the sum of t₂ and t₃ must be less than thirty seconds. For purposes of the Vertical Burn Test, control samples were limited with 125 ± 5 mm length x 13.0 ± 0.5 mm width x sample thickness

A material is designated as V-0 if test demonstrate the following characteristics:
- Specimens must not burn with flaming combustion for more than 10 either test fire application.
- Total flaming combustion time must not exceed 50 seconds for each set of 5
- Specimens must not burn with flaming or glowing combustion up to the holding clamp.
- Specimens must not drip flaming particles that ignite the
- No specimen can have glowing combustion remain for longer than 30 seconds removal of the test fire.

The tested material was rated V-0.

### Example 2

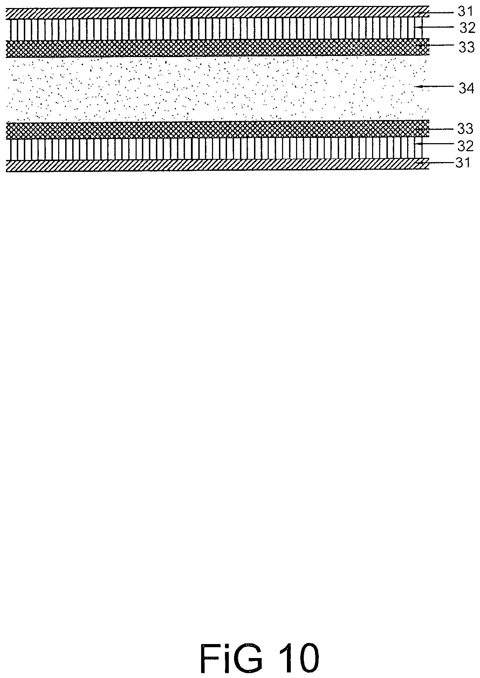

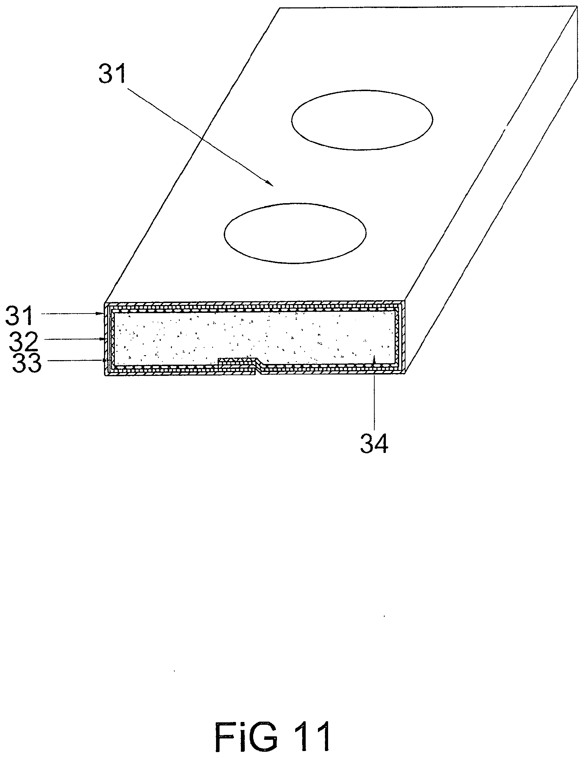

A gasket comprising the invention is made as described above, by applying a sheath to a pre-formed foam core. The halogen-free foam contains aligned conductive filler, providing conductivity in all three axes. The foam can be rated V0, VI or less for flammability as per Underwriters Laboratories Inc.'s specification UL94. The conductive sheath is C12, *supra.* The structure is shown in Figures 10 and 11. As shown in Figure 10, conductive foam 34 is covered by a sheath comprising top coating 31 and plated fiber 32, and adhered by adhesive 33.

The conductive sheath can be bonded to the conductive foam by conductive adhesives. In this example, non-conductive adhesive was used, but it was important to apply in a pattern to avoid complete coverage of the adhesive to make sure that there was an electrical liaison between the surfaces of the foam and sheath.

The resulting gasket is die-cut to incorporate openings in function of the applications so that any section exposed after cutting remains conductive, and electrically bonded to the outside conductive sheath and therefore to the metal flanges of the application.

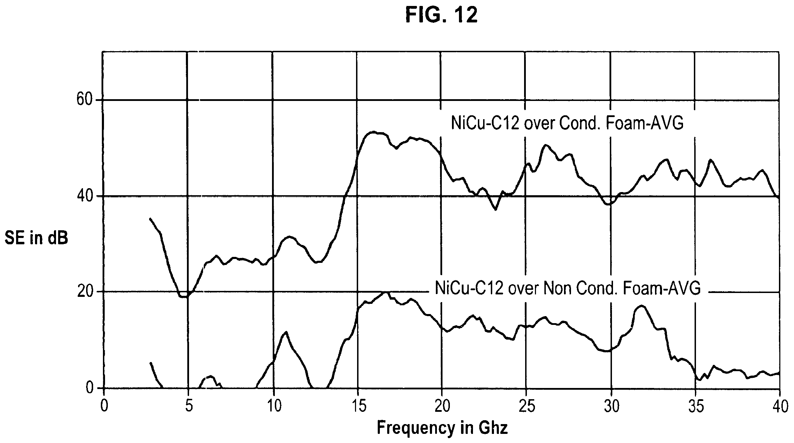

The gasket demonstrated good shielding/grounding characteristics on a broadband from 1 to 40 GHz for die-cut designs when measured by the stripline method described in Catrysse et al., Expanding The Stripline Measuring Setup For The Characterisation Of Conductive Gaskets Up To 40 GHz, 2012 IEEE International Symposium on Electromagnetic Compatibility location:Pittsburgh, Pennsylvania, USA date:5-10 August, 2012 (available at https://lirias.kuleuven.be/bitstream/123456789/276766/1/PID1296609.pdf). The results are shown in figure 12.

The above disclosure is exemplary in nature and is provided for purposes of illustration and description. Thus, variations are intended and expected, and the disclosure is not intended to be exhaustive or to limit the invention. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the invention, and all such modifications are intended to be included within the scope of the invention.

## Claims

1. An EMI shielding gasket (10) comprising: a first conductive layer (16) and polymeric foam (12) which are bonded by a polymeric layer (15, 17, 18, 19, 20), the first conductive layer (16) surrounding said polymeric foam (12) so as to form a cladding (14), the first conductive layer (16), polymeric foam (12) and any adhesive or bonding agent (15, 17, 18, 19, 20) being halogen-free and flame retardant,
**characterized in that** the gasket (10) further comprises an adhesive tape (25, 25A, 25B) and a bump (13) disposed in proximity to said adhesive tape (25, 25A, 25B), the polymeric foam (12) being conductive,
wherein the bump (13) and the adhesive tape (25A, 25B) are juxtaposed on a side of the gasket and a thickness of the bump (13) is substantially equal to a thickness of the adhesive tape (25A, 25B), such that the gasket (10) provides good shielding starting from zero compression of the gasket.

2. The EMI shielding gasket (10) of claim 1, wherein the first conductive layer comprises a fabric substrate and a metal plating,
the polymeric foam (12) and first conductive layer (16) being bonded by a bonding agent (15, 17, 18, 19, 20) that is conductive or is non-conductive but applied in a pattern that permits continued conductivity between the first conductive layer and the polymeric foam.

3. The EMI shielding gasket (10) of claim 2, wherein the first conductive layer comprises a polyester woven substrate with a layer of copper topped by a layer of nickel.

4. The EMI shielding gasket (10) of claims 2 and 3, wherein the polymeric foam is polyurethane foam.

5. The EMI shielding gasket (10) of claim 2, wherein the polymeric foam is conductive in three axes.

6. The EMI shielding gasket (10) of claim 1, wherein the gasket (10) further comprises a relatively rigid or rigid insert (28, 29, 30).

7. The EMI shielding gasket (10) of claim 1, wherein the said polymeric layer (15, 17, 18, 19, 20) is non-conductive and comprises a first layer of a polyacrylic sealer (15, 17), a second layer of a fire-retardant coating (18), and a third layer of a halogen-free, flame retardancy-imparting back-coat (19, 20).

## Patentansprüche

1. EMI-Abschirmdichtung (10), umfassend:
eine erste leitfähige Schicht (16) und Polymerschaum (12), die durch eine Polymerschicht (15, 17, 18, 19, 20) gebunden sind, wobei die erste leitfähige Schicht (16) den Polymerschaum (12) umgibt, um so eine Umhüllung (14) zu bilden, wobei die erste leitfähige Schicht (16), Polymerschaum (12) und jeder Klebstoff oder jedes Bindemittel (15, 17, 18, 19, 20) halogenfrei und flammenhemmend ist,
**dadurch gekennzeichnet, dass** die Dichtung (10) ferner ein Klebeband (25, 25A, 25B) und eine Erhebung (13) umfasst, die in der Nähe des Klebebandes (25, 25A, 25B) angeordnet ist, wobei der Polymerschaum (12) leitfähig ist,
wobei die Erhebung (13) und das Klebeband (25A, 25B) auf einer Seite der Dichtung nebeneinanderliegen, und eine Dicke der Erhebung (13) ist im Wesentlichen gleich einer Dicke des Klebebandes (25A, 25B) derart, dass die Dichtung (10) für eine gute Abschirmung sorgt, beginnend bei null Kompression der Dichtung.

2. EMI-Abschirmdichtung (10) nach Anspruch 1, wobei die erste leitfähige Schicht ein Gewebesubstrat und eine Metallbeschichtung umfasst,
wobei der Polymerschaum (12) und die erste leitfähige Schicht (16) durch ein Bindemittel (15, 17, 18, 19, 20) gebunden sind, das leitfähig oder nicht leitfähig ist, aber in einem Muster aufgetragen ist, das eine ununterbrochene Leitfähigkeit zwischen der ersten leitfähigen Schicht und dem Polymerschaum ermöglicht.

3. EMI-Abschirmdichtung (10) nach Anspruch 2, wobei die erste leitfähige Schicht ein Polyester-Gewebesubstrat mit einer Schicht von Kupfer, getoppt durch eine Nickelschicht, umfasst.

4. EMI-Abschirmdichtung (10) nach Anspruch 2 und 3, wobei der Polymerschaum Polyurethanschaum ist.

5. EMI-Abschirmdichtung (10) nach Anspruch 2, wobei der Polymerschaum in drei Achsen leitfähig ist.

6. EMI-Abschirmdichtung (10) nach Anspruch 1, wobei die Dichtung (10) ferner eine relativ starre oder starre Einlage (28, 29, 30) umfasst.

7. EMI-Abschirmdichtung (10) nach Anspruch 1, wobei die Polymerschicht (15, 17, 18, 19, 20) nichtleitfähig ist und eine erste Schicht eines Polyacryl-Dichtmittels (15, 17), eine zweite Schicht einer flammenhemmenden Beschichtung (18) und eine dritte Schicht einer halogenfreien, Flammenhemmung verleihenden Rückendeckschicht (19, 20) umfasst.

## Revendications

1. Joint d'étanchéité de protection contre les interférences électromagnétiques (10) comprenant : une première couche conductrice (16) et une mousse polymère (12) qui sont collées par une couche polymère (15, 17, 18, 19, 20), la première couche conductrice (16) entourant ladite mousse polymère (12) de façon à former une gaine (14), la première couche conductrice (16), la mousse polymère (12) et un quelconque agent adhésif ou collant (15, 17, 18, 19, 20) étant exempts d'halogène et ignifugeants,
**caractérisé en ce que** le joint d'étanchéité (10) comprend en outre une bande adhésive (25, 25A, 25B) et une protubérance (13) disposée à proximité de ladite bande adhésive (25, 25A, 25B), la mousse polymère (12) étant conductrice,
dans lequel la protubérance (13) et la bande adhésive (25A, 25B) sont juxtaposées sur un côté du joint d'étanchéité et l'épaisseur de la protubérance (13) est sensiblement égale à l'épaisseur de la bande adhésive (25A, 25B), si bien que le joint d'étanchéité (10) fournit une bonne protection à partir d'une compression nulle du joint d'étanchéité.

2. Joint d'étanchéité de protection contre les interférences électromagnétiques (10) selon la revendication 1, dans lequel la première couche conductrice comprend un substrat en tissu et un placage métallique,
la mousse polymère (12) et la première couche conductrice (16) étant collées par un agent collant (15, 17, 18, 19, 20) qui est conducteur ou non conducteur mais qui est appliqué selon un motif qui permet une conductivité continue entre la première couche conductrice et la mousse polymère.

3. Joint d'étanchéité de protection contre les interférences électromagnétiques (10) selon la revendication 2, dans lequel la première couche conductrice comprend un substrat tissé en polyester avec une couche de cuivre recouverte d'une couche de nickel.

4. Joint d'étanchéité de protection contre les interférences électromagnétiques (10) selon les revendications 2 et 3, dans lequel la mousse polymère est une mousse de polyuréthane.

5. Joint d'étanchéité de protection contre les interférences électromagnétiques (10) selon la revendication 2, dans lequel la mousse polymère est conductrice sur trois axes.

6. Joint d'étanchéité de protection contre les interférences électromagnétiques (10) selon la revendication 1, dans lequel le joint d'étanchéité (10) comprend en outre un insert rigide ou relativement rigide (28, 29, 30).

7. Joint d'étanchéité de protection contre les interférences électromagnétiques (10) selon la revendication 1, dans lequel ladite couche polymère (15, 17, 18, 19, 20) est non conductrice et comprend une première couche d'un scellant polyacrylique (15, 17), une deuxième couche d'un revêtement ignifugeant (18), et une troisième couche de revêtement arrière sans halogène conférant un effet ignifugeant (19, 20).
